# EUROPEAN PATENT SPECIFICATION

(11) **EP 2 491 379 B1**
(45) Date of publication and mention of the grant of the patent: **10.04.2019**
(21) Application number: 10766040.9
(22) Date of filing: 14.10.2010
(51) Int. Cl.: G01N 31/22, H05K 3/26, H05K 3/34, H05K 1/02

(54) **PROCESS AND USE OF A KIT FOR DETECTING RESIDUES AND CONTAMINANTS IN AN OBJECT WITH THREE-DIMENSIONAL GEOMETRY**
VERFAHREN UND VERWENDUNG EINES KITS ZUR DETEKTION VON RÜCKSTÄNDEN UND FREMDSTOFFEN IN EINEM DREI-DIMENSIONALEN OBJEKT
PROCÉDÉ ET UTILISATION D'UN NÉCESSAIRE DE PARTS POUR DÉTECTER LES RÉSIDUS ET CONTAMINANTS DANS UN OBJET A TROIS DIMENSIONS

(30) Priority: 21.10.2009 EP 09173636; 21.10.2009 US 253564 P
(43) Date of publication of application: 29.08.2012
(73) Proprietor: Danmarks Tekniske Universitet, 2800 Lyngby (DK)
(72) Inventor: MINZARI, Daniel, DK-2942 Skodsborg (DK); STENDAHL JELLESEN, Morten, DK-2860 Søborg (DK); AMBAT, Rajan, DK-2000 Frederiksberg (DK); MØLLER, Per, DK-3230 Græsted (DK); SCHWENCKE WESTERMANN, Peter, Jacob, DK-2740 Skovlunde (DK)
(74) Representative: Zacco Denmark A/S
(86) International application number: PCT/EP2010/065396
(87) International publication number: WO 2011/048001

(56) References cited:
- EP-A1- 1 160 568
- US-A1- 2001 046 451
- US-A1- 2006 154 414
- US-A1- 2006 281 186

## Description

### FIELD OF INVENTION

The present invention relates to a process and the use of a kit comprising a composition for detecting residues and contaminants in an object with three-dimensional geometry, such as an electronic object, where the residues and contaminants arise from the production process or during service life.

### BACKGROUND OF THE INVENTION

The production of electronic objects and other objects with three-dimensional geometry, e.g. electrical circuit boards, includes a number of chemical, electrochemical and thermal processes. Such processes may leave residues that can promote for example corrosion and thereby lead to device failure during service life. Also contaminants from the environments developed during the use of an electronic object may promote corrosion and influence service life.

When focusing mainly on residues and contaminants which may promote corrosion, residues from the soldering process are of special importance. During soldering, solder flux is used to etch away oxides from the metallic surfaces which one wishes to solder on. Solder fluxes commonly consist of an alcohol, an oil component and an active component that mainly consist of organic acids. The alcohol is evaporated early in the soldering process, whereas the organic acids are intended to evaporate as late in the process as possible, in order to avoid any re-oxidation of the surface. However, in many cases the organic acids will not completely evaporate during the soldering process. Especially, if there are large components on a Printed Circuit Board (PCB) with high heat capacity or complex geometry, the distribution of residues and acid residues can be affected.

Traces of the organic acids can result in a significant reduction in corrosion resistance of the circuit (B. A. SMITH and L. J. TURBINI, 1999) and increase the conductivity by orders of magnitude. A circuit with a few locally-placed acid residues may therefore be more prone to fail than one with the same amount of acid residues which are evenly distributed. Distribution of acid residues is highly dependent on the temperature profile used during the soldering process, on the PCB design and the amount of the acid comprising flux applied during the process. Large components having high heat capacities will require longer times for heating during the soldering process, and investigations have shown that the surface temperature around such large components are commonly approx. 50°C below the soldering temperature. This means that the distribution of solder flux residues is highly dependent on components that are placed on the PCB and on the temperature profile used during the soldering process.

In principle, the residues from the soldering process could be removed by introducing cleaning processes in the production chain, but economic and environmental aspects make such additional process steps undesirable for the manufactures. Instead it is sought to monitor and control the amount of residues to a level where it is known that they will not cause errors in the desired lifetime of the device.

One way of monitoring and controlling the amount of residues and contaminants is to use the Resistivity Of Solvent Extracted (ROSE) technique.

In the ROSE technique (described in the IPC Test Methods Manual: IPC-TM-650 No. 2.3.25, 2001) an electronic circuit is immersed in a solvent that can dissolve the residues on the surface. The conductivity of the solution is then measured by passing an electric current through the solution. This gives an overall measure of the cleanliness of the PCB and an empirically determined maximum value for conductivity per surface area of the circuit is used as a pass/fail criterion for the cleanliness of the PCB.

A shortcoming of this technique is that one can only measure a value for the entire PCB, and information about the local distribution of residues is not possible. This is unfortunate, since residues in the vicinity of sensitive components like i.e. microprocessors are particularly undesirable.

Local Residue Detection Technique (LRDT) is a development of the ROSE technique, where the residues are dissolved locally on a given area (typically an area with a diameter of ca. 1 cm) where after the conductivity is measured. The disadvantage of this technique is that it is very time consuming and it may be difficult to get a well defined area when measuring in the vicinity of large components or components with complex geometry.

In the well known and well documented Gel Corrosion Testing the corrosion is tested in agar gel (Chem13 NEWS, no. 81, 1976 and http://corrosion-doctors.org/Corrosion-History/Action.htm).

A gel containing pH indicator and corrosive salts is placed on the surface to be investigated. The corrosive salts promote a corrosion attack on the surface, causing local changes in pH which can be visually observed due to the pH indicator. The common approach is to activate the gel by heating it to approx. 80 ° C, after which the pH indicator and corrosive salts are added. The fluid is then poured onto a flat surface where it hardens into a gel as the temperature falls and the material is cooled down. This gel is then lifted from the production container and can then be placed on the specimen to be searched. This approach implies that only objects of relatively small size and having flat uncomplicated surface geometry can be analyzed. For very uneven surfaces, the gel will not cover evenly, and the corrosion experiment will be misleading.

US Patent application No. 2002/0034825 relates to a process for detecting acidic fluxing agent residues on electronic components, wherein a testing liquid containing a reactive dye is contacted with the electronic components and the area of colour change on the surface of the components are measured.

International patent application WO2004/099754 relates to a sol-gel sensor capable of a color change via a charge-transfer mechanism upon detection of surface contaminants. Gel powders of silica and zirconia comprising an indicator material are prepared and dispersed in ethanol or water, and subsequently applied to the surface of interest.

The object of the present invention is to provide an improved test method for detecting and monitoring the residues and contaminants in three-dimensional objects.

### SUMMARY OF THE INVENTION

The invention accordingly relates to a process for detecting production residues or service life contaminants in an object with three-dimensional geometry wherein
- a composition comprising a viscous component in an aqueous dispersion and an indicator for detecting production residues or service life contaminants in a fluent state is applied by spraying on the surface of said object to be investigated,
- said composition is allowed to solidify,
- said residues or contaminants are identified as areas where said solidified composition visually differs from remaining composition due to a reaction product between said production residues or service life contaminants and the indicator.

The invention further relates to the use of a kit in the process of the invention comprising
- a container having spraying equipment
- a viscous component in aqueous dispersion
- an indicator for detecting production residues or service life contaminants.

By the term □ object with three-dimensional geometry □ is meant any object with a three-dimensional geometry or structure, and even a complicated geometry, such as an object having a surface mounted with small or large components. Examples range from e.g. a printed circuit assembly, with mounted components in a size as are present in integrated circuits having distances between leads as low as 200 micron and surface mounted components in a size of e.g. * *1 mm (w*h*l) to larger mounted components as e.g. cylindrical capacitors with diameter of e.g. 5 cm and height of e.g. 10 cm.

By the term □ viscous □ is meant that the component has a high viscosity. Viscosity is defined e.g. in http://en.wikipedia.org/wiki/Viscosity. The skilled person will be familiar with the term □ viscous □ and will be able to identify suitable viscous components, which according to the product specification is sufficiently fluent during manufacturing of the composition of the invention.

The term □ production residues □ refers to impurities and residues occurring from the chemical, electrochemical and thermal processes that are involved in the production of three-dimensional objects, such as electronic objects.

The term □ service life contaminants □ refer to contaminants occurring during use of the objects in question, e.g. service life contaminants from use of an electronic object being organic or inorganic with acidic, alkaline or ionic nature.

The term □ electronic object □ refers to any electronic object that is used for electronic purposes and printed circuit boards.

The term □ dispersion □ as used herein covers both a solution meaning a mixture comprising particles solved in an aqueous medium and a suspension meaning particles dispersed in an aqueous medium. The aqueous medium may be water, such as de-ionised water or water mixed with a solvent, such as an alcohol.

The basic idea is to apply a viscous component, such as a gel forming component, on to the surface of the object with three-dimensional geometry thereby immobilizing residues/impurities/contaminants at their original sites. By adding an indicator in the viscous component, such as a pH indicator or an indicator for detecting a salt or an ion, a desired reaction of the indicator with the residues or contaminants to be investigated will appear as e.g. a colour change or emission of fluorescent light. In the case of flux residues from a soldering process a pH indicator would produce a colour change due to pH changes at places where acid particles from the flux residues are present. This could give manufacturers information about whether they use a proper thermal profile during soldering, whether the optimal amounts of chemicals are used, and so on.

The composition used in the process of the present invention cannot be applied by the same procedure as e.g. described for the conventional gel technique on PCBs having complex shapes and large components. A simple approach would be to pour the composition on to the PCB while it is still hot and not yet solidified. However, this would cause residues or contaminants on the surface to be mixed into the composition, and information on the local origin of the residues or contaminants will be lost.

This problem has been solved in the present invention by using a spray technique, where the hot composition is applied by spraying while the composition is fluent, e.g. with an atomizer spray flask. The composition can be applied on very uneven surfaces in a thin layer, and mixing of any residues or contaminants on the surface will be minimal.

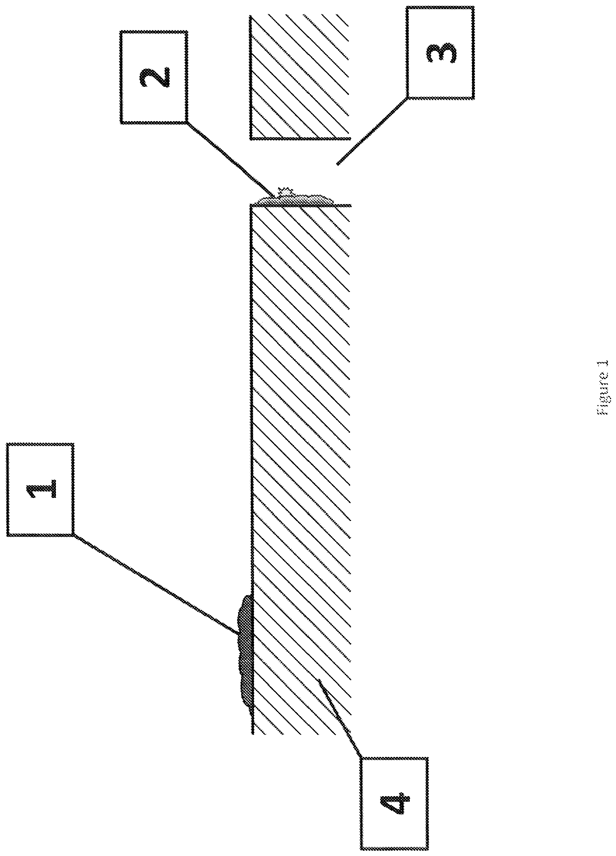

The invention is illustrated in the drawings in which
Figure 1 illustrates an example of flux residues on a printed circuit board and illustrates how active components can be trapped on holes and cavities on the board. The numbering designates the following:1: Reacted flux, 2: Unreacted flux residues (containing acidic active component), 3: Hole through printed circuit board, 4: Printed circuit board (PCB) laminate.

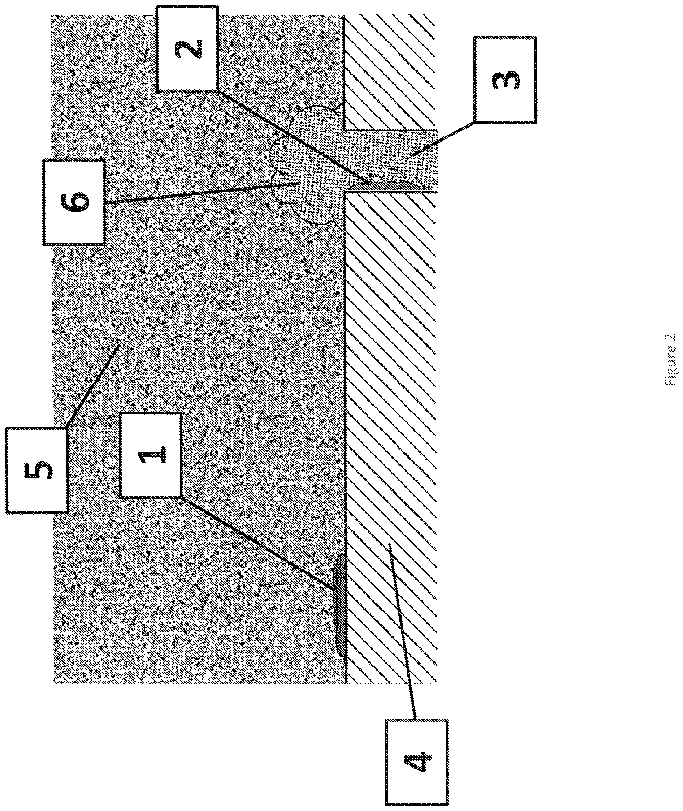

Figure 2 illustrates the detection principle in the present invention. The numbering designates the following: 1: Reacted flux, 2: Unreacted flux residues (containing acidic active component), 3: Hole through printed circuit board, 4: Printed circuit board laminate, 5: Gel layer containing indicator, 6: Colour change due to reaction with unreacted flux.
Figure 3 and 4 shows an example of flux residues on an electric component that is soldered on to a printed circuit board (a) before and (b) after application of a gel composition. The numbering designated the following: 1. Surface mount component, 2. Metallic end terminal, 3. Solder alloy, 4. Solder pad, 5. PCB laminate, 6. Reacted flux with no acid components left, 7. Unreacted flux residues (containing acidic component), 8. Gel composition, 9. Colour change due to reaction with unreacted flux.

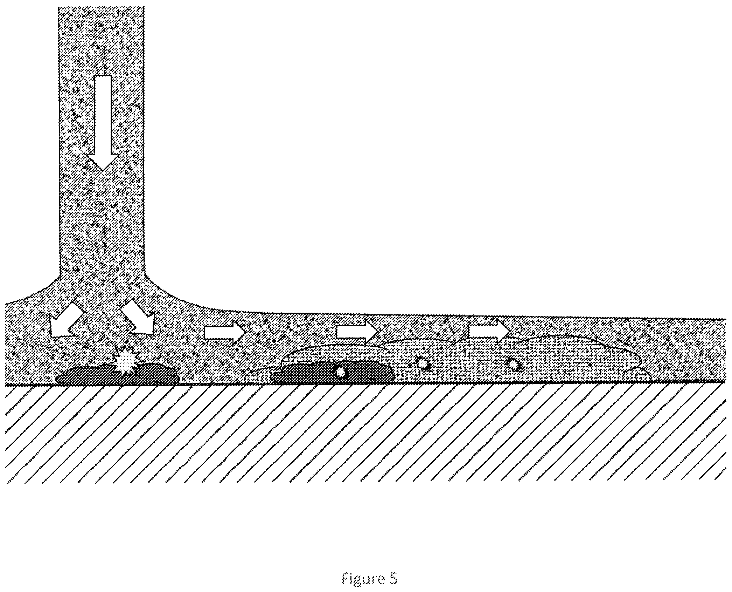

Figure 5 shows application of gel by pouring the gel on to the PCB substrate. Acid residues would be dissolved and spread into the gel, as the gel moves from the point of entry, and distributes on the surface due to gravitation forces.

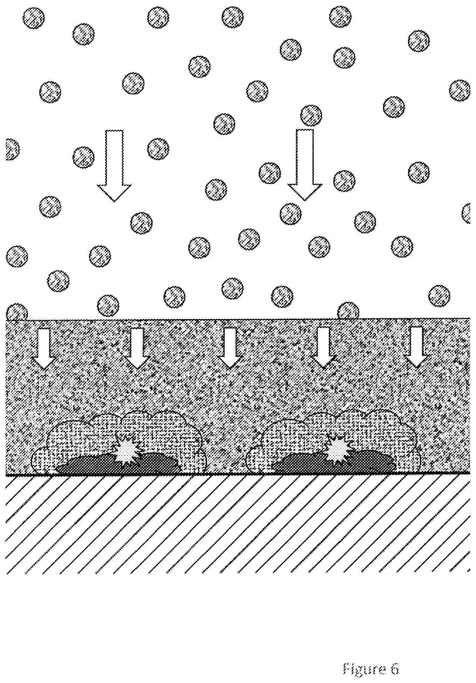

Figure 6 illustrates application of gel composition by atomizer spray according to the invention. The gel layer is gradually built without smearing within the gel, and information on the origin of harmful residues are kept visualised.
Figure 7 shows an example of application of solder flux on a PCB laminate (a) and subsequent detection by using the process of the invention after heating the laminates to (b) room temperature (no heating), (c) 175°C and (d) 235°C.
Figure 8 shows a thermographic analysis (TGA) of adipic acid at two different heating rates. The graph shows that adipic acid starts to evaporate at temperatures exceeding 170 degrees. However, it can also be noted, that a significant amount of acid is left at the surface if heating is insufficient (P. J. S. WESTERMANN et al, 2008).
Figure 9a to 9f illustrates the effect of spraying according to the invention versus pouring of a high viscosity gel on a PCB.

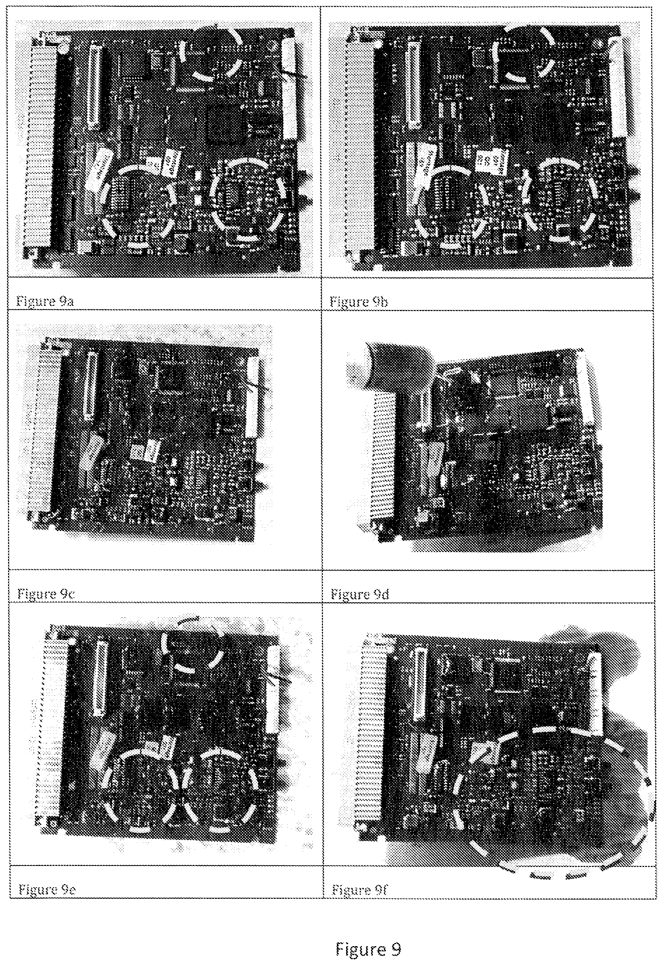

   Figure 9a illustrates 3 times 20 micro liter flux added;
   Figure 9b illustrates 3 times 20 micro liter flux added;
   Figure 9c illustrates the process of spraying a composition;
   Figure 9d illustrates the process of pouring a composition with a syringe;
   Figure 9e illustrates the result after 2 minutes: 3 local regions appear red coloured;
   Figure 9f illustrates the result after 2 minutes: One large region of red colouring.

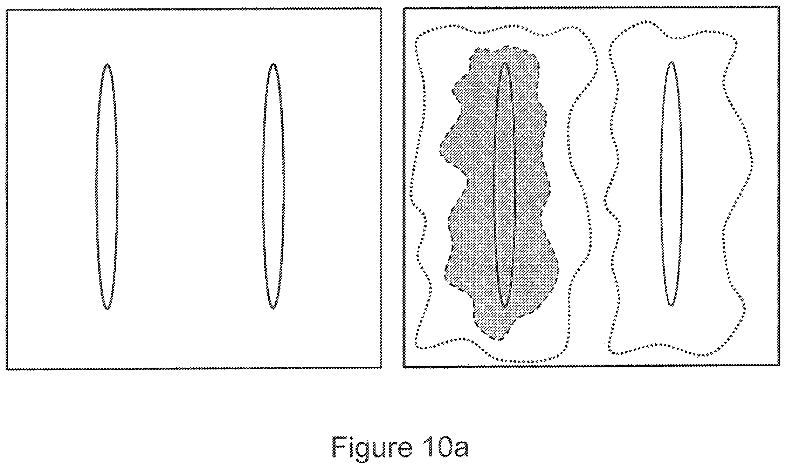

Figure 10a shows sketches of Pb indicator experiments, and

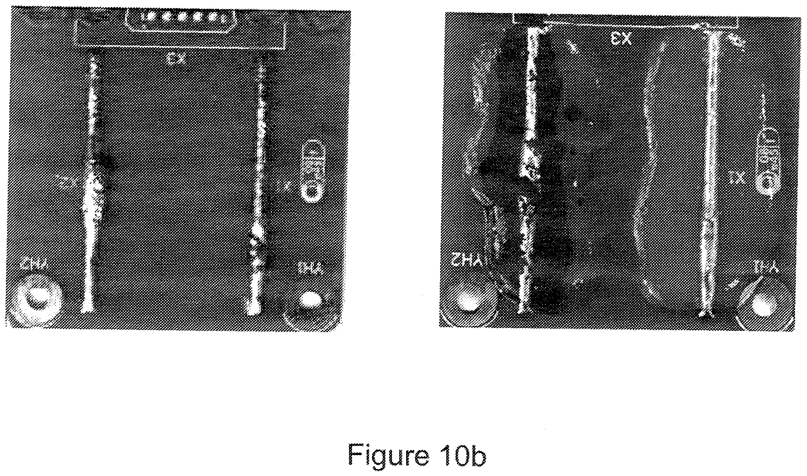

Figure 10b shows the results of a test with an indicator of Pb ions. Results are shown for the application of a composition in agreement with the process of the invention comprising the Pb indicator and for the application of a similar composition not including any Pb indicator. The picture was taken 1-2 minutes after application of the composition.

### DETAILED DESCRIPTION OF THE INVENTION

In one embodiment of the process of the invention the object with three-dimensional geometry is an electronic object.

The viscous component in the composition used in the process and kit of the invention may be any hydrocolloid or viscous fluid containing water. In one embodiment of the invention the viscous component is ion conducting, has gel forming properties and does not degrade at high or low pH. In this connection by high or low pH is meant pH over 10, 9 or even 8 or pH under 4, 5 or even 6.

In Wikipedia, see http://en.wikipedia.org/wiki/Colloid, a hydrocolloid is defined as a colloid system wherein the colloid particles are dispersed in water. A hydrocolloid has colloid particles spread throughout water, and depending on the quantity of water available it can take place in different states, e.g., gel or sol (liquid). Hydrocolloids can be either irreversible (single-state) or reversible.

For example, agar, a reversible hydrocolloid of seaweed extract, can exist in a gel and sol state, and alternate between states with the addition or elimination of heat. Many hydrocolloids are derived from natural sources. For example, agar-agar and carrageenan are extracted from seaweed, gelatine is produced by hydrolysis of proteins of bovine and fish origins, and pectin is extracted from citrus peel and apple pomace.

A colloid is a type of chemical mixture in which one substance is dispersed evenly throughout another. The particles of the dispersed substance are only suspended in the mixture, unlike in a solution, in which they are completely dissolved. This occurs because the particles in a colloid are larger than in a solution - small enough to be dispersed evenly and maintain a homogeneous appearance, but large enough to scatter light and not dissolve. Because of this dispersal, some colloids have the appearance of solutions. A colloidal system consists of two separate phases: a dispersed phase (or internal phase) and a continuous phase (or dispersion medium). A colloidal system may be solid, liquid, or gaseous.

In one embodiment of the process of the invention the viscous component is a gel forming agar. By this term is meant an agar as defined in Wikipedia, see http://en.wikipedia.org/wiki/Agar. Detailed information on agar can be found on (http://www.fao.org/docrep/field/003/AB730E/AB730E03.htm).

In other embodiments the viscous component is a gel forming protein, polysaccharide or carbohydrate, such as a carrageenan, gelatine or a pectin.

It is important that the viscous component is not sensible towards pH fluctuations. If the component is sensible, this could result in degrading from the solidified stage due to pH changes during the detecting process or in the detecting equipment.

The viscosity of the composition can easily be modified by changing the ratio of agar or other high viscosity component in the composition.

The production residues or service life contaminants can be any impurities that arise as the result of a process for manufacturing an object with three-dimensional geometry or during the service life of an object. In one embodiment of the process of the invention residues may result from a soldering process. In another embodiment the residues are salts and/or ions resulting from the manufacturing process of the object.

Examples of production residues or service life contaminants are solder flux residues, alcohols, oil components, acidic components, organic acids, components comprising acids, dust or other airborne contaminations. In some embodiments of the invention the residues or contaminants are bromide ions, chloride ions and/or lead ions.

In other embodiments of the invention the residues are production residues from the solder flux used in a soldering process, e.g. an organic acid, such as adipic acid, glutaric acid or succinic acid, alcohols, oil components, resin oils, ester oils and acid crystal.

The indicator used in the process of the invention for detecting the production residues or service life contaminants may e.g. be an indicator where a reaction product between the indicator and the production residues or the service life contaminants will appear either as a colour change or emission of fluorescent light. In one embodiment the indicator is a pH indicator, which produces a colour change at places where acid particles, e.g. acid particles from a soldering process, are present.

Example of a suitable pH indicator is an universal indicator with a pH range of 3.0 to 10.0.

Many other indicators could be used, depending on the nature of the residue or contaminants to be analysed, e.g. indicators that react with a given salt, a given ion, etc., such as chloride, bromide and lead indicators. Example of a lead indicator is sulphide hydrates, such as nona hydrates.

A suitable amount of viscous component is from 1 to 10 g/100 ml aqueous dispersion, e.g. from 2 to 5 g/100ml, such as 2 to 3 mg/100 ml dispersion.

Examples of objects with three-dimensional geometry are electronic objects, such as electronic circuits, printed circuit boards and printed circuit board assemblies.

The process of the invention is carried out at a state where the composition is kept as a fluid. If the composition is an agar a temperature is used, where the agar is fluent according to the product information. A suitable temperature may be 60 to 100 °C, e.g. 80-90°C, such as 75 to 80 °C. The composition is solidified by cooling to a temperature, by a chemical cross linking of the hydrocolloid suspension, by evaporation of a solvent or any other process, where the applied composition solidifies according to the product description. If an agar is used, the cooling may be to e.g. a temperature of 30 to 40 °C.

The residues or contaminants indicator may be used in an amount that is recommended according to the product description for the product in question. A pH indicator may e.g. be used in an amount of from 15 to 30 ml/100ml water or composition.

Thus, according to one aspect of the invention the invention relates to the use of a kit comprising a composition and spraying equipment. The container may by an ordinary flask, and the spraying equipment ordinary spraying equipment, such as a flower spraying flask or the like.

The heating process can be done by placing the container or flask in a micro-oven or in a heated water bath. This method can be directly used by virtually any manufacturer of electronic circuit boards, and the only equipment to be used is a heat source (e.g. microwave or water bath) and, if necessary a camera for documentation.

The composition used in the process of the invention may also comprise a surfactant, e.g. a suitable chemical inert surfactant, or a solvent, e.g. an alcohol, such as isopropyl alcohol, enhancing the dissolution of the residues or contaminants to be identified into the gel.

The process of the invention may be carried out in accordance with the following general recipe:
The high viscosity component is mixed with de-ionized water in an amount of e.g. 2g/100ml water. A universal pH indicator, e.g. Riedel-de Ha n 36806 Universal indicator pH 3.0-10.0, is added in an amount of 15-30 ml/100 ml water.

The mixture is heated to a suitable temperature, typically 60-100°C, depending on the properties of the viscous component used, the mixture is filled in a spraying device, and the mixture is sprayed on the object to be investigated. The object comprising the applied composition is cooled to solidify the viscous component to a gel. The resulting gel is inspected visually for colour changes and optionally photos are taken.

The invention will now be described in further detail with reference to the following examples.

### EXAMPLES

### Example 1

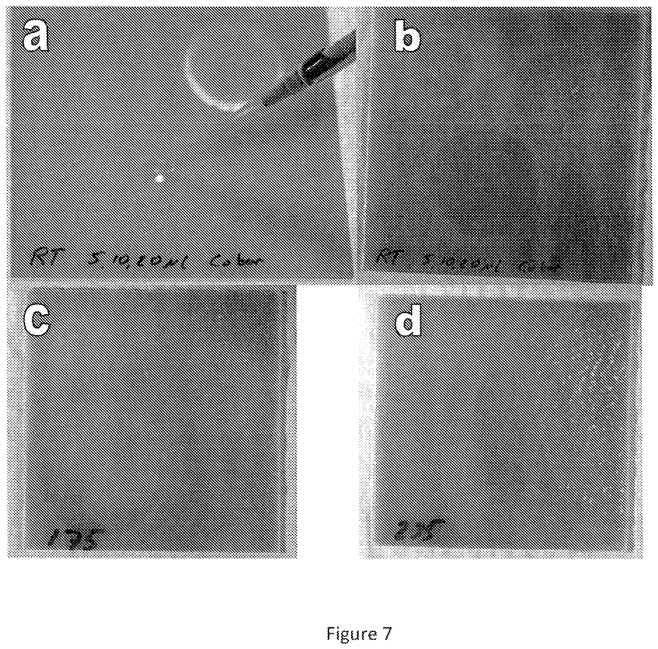

In a control experiment illustrated in figure 7 solder flux has been added to a plain laminate in three different amounts (a) and left to dry at room temperature. After application of the gel, the solder flux is clearly seen on the red coloured areas (b). Laminates were additionally heated to 175°C (c) and 235°C (d) in order to simulate incomplete and correct soldering temperatures respectively. It is clearly observed that the acid content is reduced at 175°C heating, and no acid residues are found after 235°C.

### Example 2

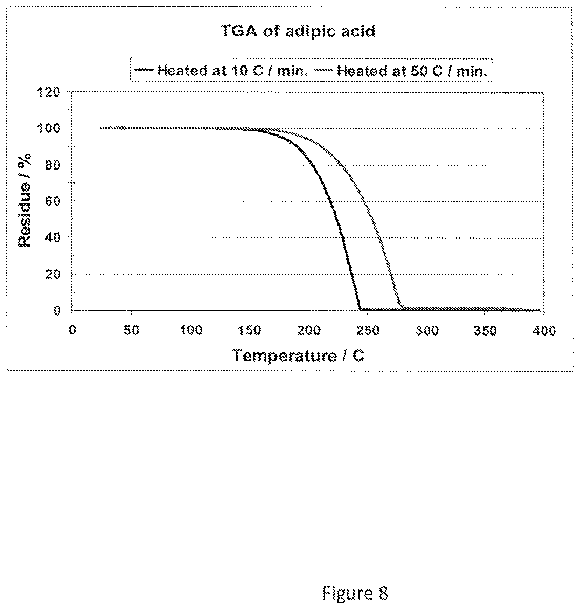

In order to validate the evaporation of the acidic component of a solder flux, thermo gravimetric analysis (TGA) was performed on adipic acid (P. Westermann et al, 2008), which is a carboxylic acid commonly found in soldering fluxes. Results at two different heating rates are presented in figure 8. It is clearly seen, that the adipic acid is evaporating at temperatures that are exceeding approx. 170°C and that most of the acid are evaporated at temperatures around approx. 230°C.

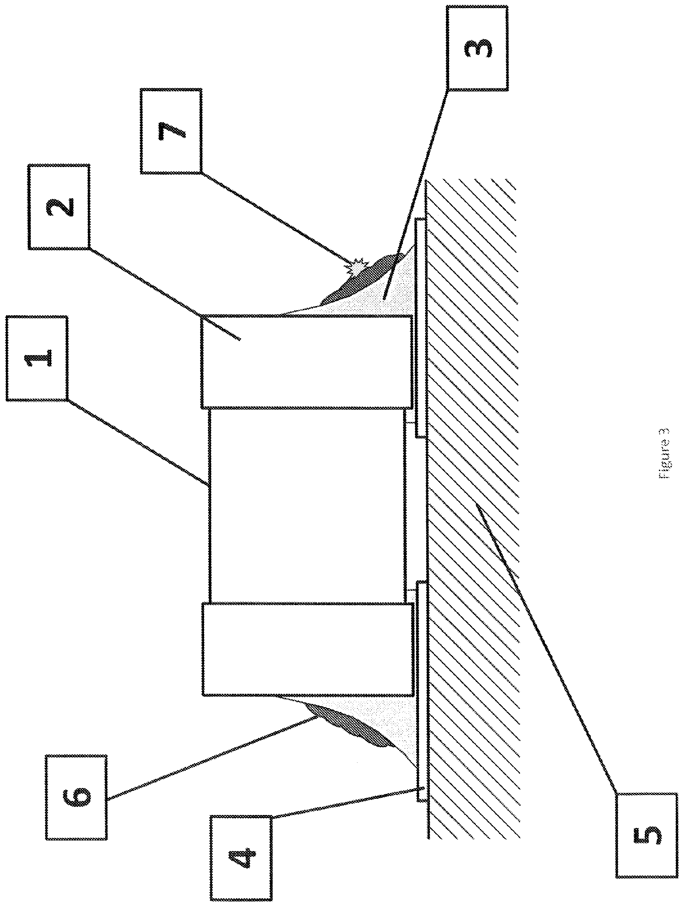

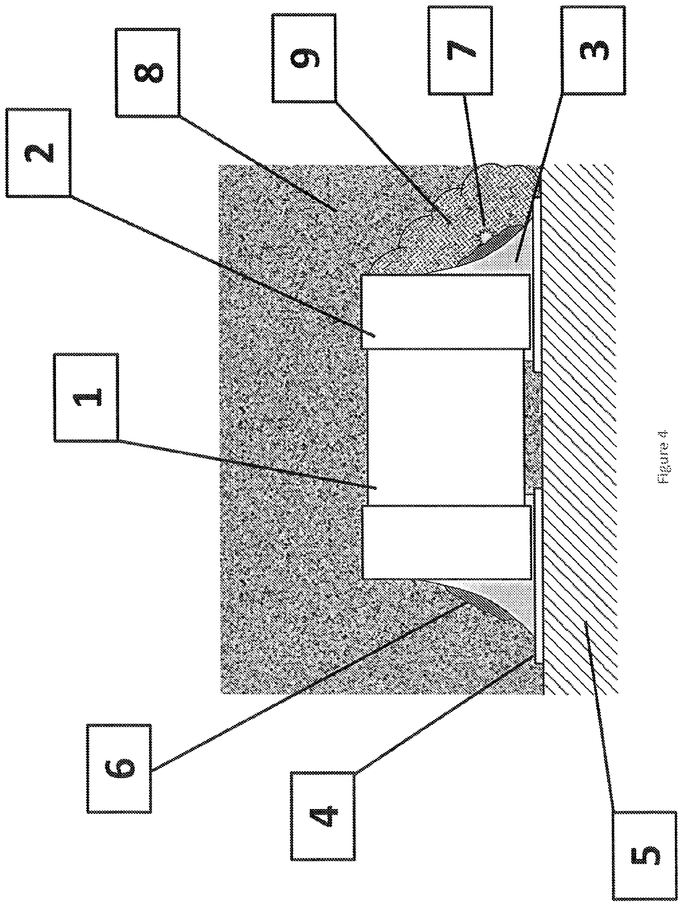

These results are in very good compliance with the findings of the visual inspection using the present invention as illustrated in figures 3 and 4.

### Example 3

Figure 9 illustrates the results achieved when using the spraying process of the invention in comparison with a pouring process.

3 times 20 I solder flux was applied to two identical PCBS. An agar composition were poured or sprayed, respectively, to the two PCBs □, and the gels were allowed to solidify.

After 2 minutes separate local areas appeared on the PCB, where the gel is applied by spraying, while one larger area appeared on the control PCB.

### Example 4

Figure 10 illustrates the results achieved when using the spraying process of the invention for detecting lead ions.

3 g agar was dissolved in 100 ml distilled water, and 30 ml Pb indicator consisting of 0.6 M sodium sulphide nonahydrate was added.

The resulting composition was applied on one half of a PCB with a strip of lead containing solder paste, whereas a composition without the Pb indicator was applied on a similar strip of the solder paste on the other half of the PCB. The compositions were allowed to solidify. As seen in figure 10b (left part of the figure), a significant dark coloration of the gel part containing the Pb indicator appeared, whereas the part (right part of the figure) which did not comprise any Pb indicator remained uncoloured.

The amount of water, agar and indicator can be varied to reach optimal viscosity.

### REFERENCES

Peter Jacob Schwencke Westermann et al, 2008, Department for Mechanical Engineering, Technical University of Denmark.
Brian A. Smith and Laura J. Turbini, □ Characterizing the Weak Organic Acids Used in Low Solids Fluxes □ Journal of ELECTRONIC MATERIALS, Vol. 28, No 11, 1999

## Claims

1. A process for detecting production residues or service life contaminants in an object with three-dimensional geometry wherein
• a composition comprising a viscous component in aqueous dispersion and an indicator for detecting production residues or service life contaminants in a fluent state is applied by spraying on the surface of said object to be investigated,
• said composition is allowed to solidify,
• said residues or contaminants are identified as areas, where said solidified composition visually differs from remaining composition due to a reaction product between said production residues or service life contaminants and the indicator.

2. Process according to claim 1, wherein said object with three-dimensional geometry is an electronic object.

3. Process according to claims 1 or 2, wherein the production residues or service life contaminants are flux residues resulting from a soldering process.

4. Process according to any of the claims 1 to 3, wherein the production residues or service life contaminants are alcohols, oil components, acidic components, components comprising or consisting of organic acids, adipic acid, glutaric acid, succinic acid, dust or other airborne contaminations.

5. Process according to any of the claims 1 to 4, wherein the production residues or service life contaminants are bromide ions, chloride ions or lead ions.

6. Process according to any of the claims 1 to 5, wherein the production residues or service life contaminants are selected from organic acids, alcohols, oil components, resin oils, ester oils and acid crystals.

7. Process according to any of the claims 1 to 6, wherein the object is an electronic circuit, a printed circuit board or a printed circuit board assembly.

8. Process according to any of the claims 1 to 7, wherein said composition is applied at a temperature between 60 and 100 °C.

9. Process according to any of the claims 1 to 8, wherein said residues or contaminants are identified as areas, which visually appear as a colour change or emission of fluorescent light.

10. Process according to any of the claims 1 to 9, wherein said composition is comprised in a container comprising spraying equipment.

11. Process according to claim 10, wherein said container with spraying equipment is an atomizer flask.

12. Process according to any of the claims 10 to 11, wherein said container is heated to a temperature where said composition is fluent, and said fluent composition is applied by spraying on the surface of said object to be investigated.

13. Use of kit comprising
• a container having spraying equipment
• a viscous component in aqueous dispersion
• an indicator for detecting production residues or service life contaminants
in a process according to any of the claims 1 to 12.

14. Use according to claim 13, wherein said viscous component is a gel forming hydrocolloid or a viscous fluid containing water.

15. Use according to any of the claims 13 or 14, wherein the viscous component is ion conducting, has gel forming properties and does not degrade at high or low pH.

16. Use according to any of the claims 13 to 15, wherein the viscous component is a gel forming agar.

17. Use according to any of the claims 13 to 16, wherein the indicator is a pH indicator.

18. Use according to claim 17, wherein the pH indicator is an indicator, which produces a colour change with acid particles.

19. Use according to any of the claims 13 to 16, wherein the indicator is an indicator for detecting a salt or an ion.

20. Use according to any of the claims 13 to 19 further comprising a solvent suitable for enhancing dissolution of said residues or contaminants to be identified.

21. Use according to any of the claims 13 to 20, wherein the solvent is an alcohol, such as isopropyl alcohol.

22. Use according to any of the claims 13 to 21, wherein said container having spraying equipment is a spraying flask.

## Patentansprüche

1. Verfahren zur Detektion von Rückständen oder Kontaminanten der Lebensdauer mit dreidimensionaler Geometrie, wobei
• eine Zusammensetzung umfassend eine viskose Komponente in wässriger Dispersion und einen Indikator zur Detektion von Produktionsrückständen oder Kontaminanten der Lebensdauer in einem flüssigen Zustand durch Sprühen auf die Oberfläche des zu untersuchenden Objektes aufgetragen wird,
• die Zusammensetzung wird verfestigt,
• die Rückstände oder Kontaminanten als Bereiche identifiziert werden, in denen sich die verfestigte Zusammensetzung infolge eines Reaktionsproduktes zwischen den Produktionsrückständen oder Kontaminanten der Lebensdauer und dem Indikator von der verbleibenden Zusammensetzung visuell unterscheidet.

2. Verfahren nach Anspruch 1, wobei das Objekt mit dreidimensionaler Geometrie ein elektronisches Objekt ist.

3. Verfahren nach Anspruch 1 oder 2, wobei die Produktionsrückstände oder Kontaminanten der Lebensdauer Flussmittelrückstände sind, die aus einem Lötverfahren entstehen.

4. Verfahren nach einem der Ansprüche 1 bis 3, wobei die Produktionsrückstände oder Kontaminanten der Lebensdauer Alkohole, Ölkomponenten, sauren Komponenten, Komponenten umfassend bzw. bestehend aus organische(n) Säuren, Adipinsäure, Glutarsäure, Bernsteinsäure, Staub oder andere(n) luftgetragene(n) Kontaminationen sind.

5. Verfahren nach einem der Ansprüche 1 bis 4, wobei die Produktionsrückstände oder Kontaminanten der Lebensdauer Bromid-Ionen, Chlorid-Ionen oder Blei-Ionen sind.

6. Verfahren nach einem der Ansprüche 1 bis 5, wobei die Produktionsrückstände oder Kontaminanten der Lebensdauer aus organischen Säuren, Alkoholen, Ölkomponenten, Harzölen, Esterölen und Säurekrystallen ausgewählt sind.

7. Verfahren nach einem der Ansprüche 1 bis 6, wobei das Objekt eine elektronische Schaltung, eine Leiterplatte oder eine Leiterplattenanordnung ist.

8. Verfahren nach einem der Ansprüche 1 bis 7, wobei die Zusammensetzung bei einer Temperatur zwischen 60 und 100 °C aufgetragen wird.

9. Verfahren nach einem der Ansprüche 1 bis 8, wobei die Rückstände oder Kontaminanten als Bereiche, die als eine Farbänderung oder Aussendung von Fluorescenzlicht erscheinen, identifiziert werden.

10. Verfahren nach einem der Ansprüche 1 bis 9, wobei die Zusammensetzung in einem Behälter umfassend Spritzausrüstung aufgenommen ist.

11. Verfahren nach Anspruch 10, wobei der Behälter mit Spritzausrüstung eine Zerstäuberflasche ist.

12. Verfahren nach einem der Ansprüche 10 bis 11, wobei der Behälter auf eine Temperatur erhitzt wird, bei der die Zusammensetzung flüssig ist, und die flüssige Zusammensetzung durch Sprühen auf die Oberfläche des zu untersuchenden Objektes aufgetragen wird.

13. Verwendung eines Kits umfassend
• einen Behälter mit Spritzausrüstung
• eine viskose Komponente in wässriger Dispersion
• einen Indikator zur Detektion von Produktionsrückständen oder Kontaminanten der Lebensdauer
bei einem Verfahren nach einem der Ansprüche 1 bis 12.

14. Verwendung nach Anspruch 13, wobei die viskose Komponente ein gelbildendes Hydrokolloid oder eine wasserhaltige viskose Flüssigkeit ist.

15. Verwendung nach einem der Ansprüche 13 oder 14, wobei die viskose Komponente ionenleitend ist, gelbildende Eigenschaften aufweist und bei hohem oder niedrigem pH-Wert nicht abgebaut wird.

16. Verwendung nach einem der Ansprüche 13 bis 15, wobei die viskose Komponente ein gelbildendes Agar ist.

17. Verwendung nach einem der Ansprüche 13 bis 16, wobei der Indikator ein pH-Indikator ist.

18. Verwendung nach Anspruch 17, wobei der pH-Indikator ein Indikator ist, der eine Farbänderung mit sauren Partikeln erzeugt.

19. Verwendung nach einem der Ansprüche 13 bis 16, wobei der Indikator ein Indikator zur Detektion eines Salzes oder eines Ions ist.

20. Verwendung nach einem der Ansprüche 13 bis 19, ferner umfassend ein Lösungsmittel, das zur Verbesserung der Löslichkeit der zu identifizierenden Rückstände oder Kontaminanten geeignet ist.

21. Verwendung nach einem der Ansprüche 13 bis 20, wobei das Lösungsmittel ein Alkohol, wie beispielsweise Isopropylalkohol, ist.

22. Verfahren nach einem der Ansprüche 13 bis 21, wobei der Behälter mit Spritzausrüstung eine Zerstäuberflasche ist.

## Revendications

1. Procédé de détection de résidus de production ou de contaminants de durée de vie dans un objet à géométrie tridimensionnelle dans lequel
• une composition comprenant un composant visqueux en dispersion aqueuse et un indicateur de détection de résidus de production ou de contaminants de durée de vie à l'état fluide est appliquée par pulvérisation sur la surface dudit objet à étudier,
• on laisse ladite composition se solidifier,
• on identifie lesdits résidus ou contaminants en tant que zones, où ladite composition solidifiée diffère visuellement de la composition restante en raison d'un produit de réaction entre lesdits résidus de production ou contaminants de durée de vie et l'indicateur.

2. Procédé selon la revendication 1, dans lequel ledit objet à géométrie tridimensionnelle est un objet électronique.

3. Procédé selon la revendication 1 ou 2, dans lequel les résidus de production ou les contaminants de durée de vie sont des résidus de flux résultant d'un processus de brasage.

4. Procédé selon l'une quelconque des revendications 1 à 3, dans lequel les résidus de production ou les contaminants de durée de vie sont des alcools, des composants d'huile, des composants acides, des composants comprenant ou constitués par des acides organiques, de l'acide adipique, de l'acide glutarique, de l'acide succinique, de la poussière ou d'autres contaminants en suspension dans l'air.

5. Procédé selon l'une quelconque des revendications 1 à 4, dans lequel les résidus de production ou les contaminants de durée de vie sont des ions bromures, des ions chlorures ou des ions plomb.

6. Procédé selon l'une quelconque des revendications 1 à 5, dans lequel les résidus de production ou les contaminants de durée de vie sont choisis parmi les acides organiques, les alcools, les composants d'huile, les huiles de résine, les huiles d'esters et les cristaux d'acide.

7. Procédé selon l'une quelconque des revendications 1 à 6, dans lequel l'objet est un circuit électronique, une carte de circuit imprimé ou un ensemble de carte de circuit imprimé.

8. Procédé selon l'une quelconque des revendications 1 à 7, dans lequel ladite composition est appliquée à une température comprise entre 60 et 100 °C.

9. Procédé selon l'une quelconque des revendications 1 à 8, dans lequel lesdits résidus ou contaminants sont identifiés en tant que zones, qui apparaissent visuellement en tant que changement de couleur ou qu'émission de lumière fluorescente.

10. Procédé selon l'une quelconque des revendications 1 à 9, dans lequel ladite composition est comprise dans un récipient comprenant un équipement de pulvérisation.

11. Procédé selon la revendication 10, dans lequel ledit récipient avec un équipement de pulvérisation est un flacon atomiseur.

12. Procédé selon l'une quelconque des revendications 10 à 11, dans lequel ledit récipient est chauffé à une température où ladite composition est fluide, et ladite composition fluide est appliquée par pulvérisation sur la surface dudit objet à étudier.

13. Utilisation d'un kit comprenant
• un récipient avec un équipement de pulvérisation
• un composant visqueux en dispersion aqueuse
• un indicateur pour la détection de résidus de production ou de contaminants de durée de vie
dans un procédé selon l'une quelconque des revendications 1 à 12.

14. Utilisation selon la revendication 13, dans laquelle ledit composant visqueux est un hydrocolloïde formant un gel ou un fluide visqueux contenant de l'eau.

15. Utilisation selon l'une quelconque des revendications 13 ou 14, dans laquelle le composant visqueux est conducteur ionique, présente des propriétés de gélification et ne se dégrade pas à pH élevé ou bas.

16. Utilisation selon l'une quelconque des revendications 13 à 15, dans laquelle le composant visqueux est un agar formant un gel.

17. Utilisation selon l'une quelconque des revendications 13 à 16, dans laquelle l'indicateur est un indicateur de pH.

18. Utilisation selon la revendication 17, dans laquelle l'indicateur de pH est un indicateur qui produit un changement de couleur avec des particules d'acide.

19. Utilisation selon l'une quelconque des revendications 13 à 16, dans laquelle l'indicateur est un indicateur pour détecter un sel ou un ion.

20. Utilisation selon l'une quelconque des revendications 13 à 19, comprenant en outre un solvant approprié pour améliorer la dissolution desdits résidus ou contaminants à identifier.

21. Utilisation selon l'une quelconque des revendications 13 à 20, dans laquelle le solvant est un alcool, tel que l'alcool isopropylique.

22. Utilisation selon l'une quelconque des revendications 13 à 21, dans laquelle ledit récipient comportant un équipement de pulvérisation est un flacon de pulvérisation.
